# EUROPÄISCHE PATENTSCHRIFT

(11) **EP 2 316 142 B1**
(45) Veröffentlichungstag und Bekanntmachung des Hinweises auf die Patenterteilung: **30.09.2015**
(21) Anmeldenummer: 09781957.7
(22) Anmeldetag: 18.08.2009
(51) Int. Cl.: H01L 41/293, H01L 41/047

(54) **PIEZOAKTOR IN VIELSCHICHTBAUWEISE**
PIEZOACTUATOR IN MULTI-LAYERED CONSTRUCTION
ACTIONNEUR PIÉZOÉLECTRIQUE DE CONCEPTION MULTICOUCHE

(30) Priorität: 18.08.2008 DE 102008038227; 12.12.2008 DE 102008062021
(43) Veröffentlichungstag der Anmeldung: 04.05.2011
(73) Patentinhaber: Epcos AG, 81669 München (DE)
(72) Erfinder: RESZAT, Jan-Thorsten, 76137 Karlsruhe (DE); RINNER, Franz, A-8530 Deutschlandsberg (AT); GABL, Reinhard, A-6330 Kufstein (AT); LAUSSERMAYER, Markus, A-8521 Wettmannstätten (AT)
(74) Vertreter: Epping - Hermann - Fischer
(86) Internationale Anmeldenummer: PCT/EP2009/060676
(87) Internationale Veröffentlichungsnummer: WO 2010/020643

(56) Entgegenhaltungen:
- WO-A-01/78158
- WO-A-01/91199
- WO-A1-02/39510
- DE-A1- 19 928 189
- DE-A1- 19 930 585
- DE-A1-102006 000 536

## Beschreibung

Es wird ein Piezoaktor angegeben, der aus einer Vielzahl piezoelektrischer Schichten mit dazwischen liegenden Elektrodenschichten aufgebaut ist. Beim Anlegen einer elektrischen Spannung an die Elektrodenschichten dehnen sich die piezoelektrischen Schichten aus, wodurch ein Hub erzeugt wird. Derartige Piezoaktoren werden beispielsweise zur Betätigung eines Einspritzventils in einem Kraftfahrzeug eingesetzt.

Beim Betrieb des Piezoaktors können mechanische Spannungen auftreten und Risse, insbesondere auch an einer Außenelektrode, entstehen. Dadurch kann es zum Ausfall des Piezoaktors kommen.

In der Druckschrift EP 0844678 B1 ist ein Piezoaktor angegeben, der eine dreidimensional strukturierte, elektrisch leitende Elektrode aufweist, die über partielle Kontaktstellen mit einer Grundmetallisierung verbunden ist.

Ein weiteres Beispiel findet sich in der Druckschrift WO 01/78158.

Es ist eine zu lösende Aufgabe, einen Piezoaktor mit einer Außenelektrode anzugeben, die kostengünstig herzustellen ist und eine hohe Zuverlässigkeit aufweist.

Es wird ein Piezoaktor in Vielschichtbauweise mit einem Stapel aus piezoelektrischen Schichten und dazwischen liegenden Elektrodenschichten angegeben. Der Piezoaktor weist wenigstens eine Außenelektrode zur elektrischen Kontaktierung der Elektrodenschichten auf, die als Drahtgewebe ausgebildet ist. Die Außenelektrode ist vollflächig an einer Außenseite des Stapels befestigt.

Vorzugsweise ist der Piezoaktor ein monolithischer Vielschichtaktor, der aus dünnen Folien eines piezoelektrischen Materials, beispielsweise Blei-Zirkonat-Titanat(PZT), hergestellt wird. Zur Bildung der Elektrodenschichten kann mittels eines Siebdruckverfahrens eine Metallpaste, zum Beispiel eine Silber-Palladium-Paste oder eine kupferhaltige Paste, auf die Folien aufgebracht werden. Die Folien werden anschließend gestapelt, verpresst und gemeinsam gesintert. Somit entsteht ein monolithischer Sinterkörper, bei dem alle Schichten gemeinsam gesintert sind. Die Elektrodenschichten sind vorzugsweise so ausgeführt, dass sie entlang der Stapelrichtung des Piezoaktors abwechselnd bis an eine Seitenfläche des Stapels herausgeführt sind und gegenüber einer weiteren Seitenfläche zurückversetzt sind. Zur elektrischen Kontaktierung der Elektrodenschichten können auf den zwei Seitenflächen Außenelektroden angebracht sein. Die Elektrodenschichten sind dann in Stapelrichtung abwechselnd mit einer der Außenelektroden elektrisch verbunden und weisen einen Abstand zur zweiten Außenelektrode auf.

Mindestens eine der Außenelektroden ist ein Drahtgewebe, das miteinander verwebte Drähte aufweist. Bei einer vollflächigen Befestigung des Drahtgewebes sind wenigstens die Bereiche der Drähte, die an die Außenseite des Stapels angrenzen, an der Außenseite des Stapels befestigt.

Auf diese Weise sind die Außenelektroden fest mit dem Piezoaktor verbunden und es wird eine zuverlässige Kontaktierung erzielt. Zudem wird durch die Befestigung derjenigen Drahtabschnitte, die an der Außenseite des Stapels anliegen, eine Relativbewegung der Drahtabschnitte zur Außenseite und somit ein Scheuern der Drähte an der Außenseite des Stapels verhindert.

Vorzugsweise sind diejenigen Drahtabschnitte, die sich auf einer Seite des Drahtgewebes befinden, die der Außenseite des Stapels zugewandt ist, mit der Außenseite des Stapels fest verbunden. Dabei ist ein Drahtabschnitt der Außenseite des Stapels zugewandt, wenn er direkt von der Außenseite des Stapels aus zugänglich ist. Dies sind beispielsweise diejenigen Drahtabschnitte, die von der Außenseite des Stapels aus senkrecht nach oben gehend, getroffen werden. Insbesondere befinden sich zwischen einem Drahtabschnitt, der der Außenseite des Stapels zugewandt ist, und der Außenseite des Stapels keine weiteren Drahtabschnitte.

Vorzugsweise liegt das Drahtgewebe vollflächig auf dem Stapel auf. Dies hat den Vorteil, dass eine besonders platzsparende Kontaktierung des Piezoaktors erreicht werden kann. In diesem Fall sind vorzugsweise alle Drähte an der Außenseite des Stapels befestigt.

Durch die bevorzugte Verwebung der Drähte ergeben sich allerdings Maschenknoten, bei denen ein Draht oben liegt und ein Draht unten liegt. Bei einem vollflächigen Aufliegen des Drahtgewebes soll auch der Fall eingeschlossen sein, dass im Bereich von Maschenknoten Bereiche der oben liegenden Drähte nicht direkt auf der Außenseite des Stapels aufliegen. Vorzugsweise sind diese Bereiche fest mit den unten liegenden Drähten verbunden, jedoch müssen sie nicht direkt an der Außenseite des Stapels befestigt sein. Der unten liegende Draht eines Maschenknotens, der an der Außenseite des Stapels aufliegt, ist jedoch direkt an der Außenseite des Stapels befestigt.

In einer bevorzugten Ausführungsform ist die Außenelektrode an einer Grundmetallisierung des Stapels befestigt. Die Grundmetallisierung ist auf einer Außenseite des Stapels angebracht. Beispielsweise sind auf zwei gegenüberliegenden Seitenflächen des Stapels Grundmetallisierungen aufgebracht, an denen jeweils eine Außenelektrode befestigt ist.

Vorzugsweise weist die Grundmetallisierung wenigstens eine eingebrannte metallische oder metallhaltige Paste auf. Vorzugsweise ist die eingebrannte Paste in Form einer Schicht auf dem Stapel aufgebracht.

Eine derartige Metallpaste kann beispielsweise vor dem Sintern des Stapels auf die Außenseite des Stapels aufgebracht werden. In diesem Fall wird die Metallpaste beim Sintern des Stapels mit eingebrannt, so dass sich eine sogenannte ko-gesinterte Grundmetallisierung ergibt. Alternativ dazu kann die Metallpaste nach dem Sintern des Stapels auf die Außenseite aufgebracht und anschließend eingebrannt werden. Eine derartige Grundmetallisierung kann auch mehrere übereinander aufgetragene Metallpasten aufweisen.

Beispielsweise enthält eine Metallpaste ein Metall aus der Menge Kupfer und Silber. Vorzugsweise weist eine Grundmetallisierung, die nach dem Sintern des Stapels eingebrannt wird, zumindest eine Paste auf, die einen Glasfluss-Anteil enthält. Bei mehreren übereinander aufgetragenen Metallpasten enthält vorzugsweise zumindest die an den Stapel direkt angrenzende Metallpaste einen Glasfluss-Anteil. Auf diese Weise kann eine ausreichende Haftfestigkeit der Grundmetallisierung am Stapel erreicht werden. Auf die direkt an den Stapel angrenzende Schicht der Grundmetallisierung kann eine weitere Metallpaste aufgebracht werden. Vorzugsweise enthält diese Metallpaste keinen Glasfluss-Anteil.

Vorzugsweise ist die Außenelektrode an der Grundmetallisierung angelötet. Beispielsweise wird dabei ein Lotmaterial aus der Menge Zinn, Zinnlegierung, Blei oder Antimon eingesetzt. Die Verwendung des Lotmaterials Zinn hat den Vorteil, dass keine oder nur in geringem Maße gesundheitsschädliche Materialien wie Blei oder Cadmium eingesetzt werden müssen. Vorzugsweise weist das Lotmaterial nach dem Verlöten eine gewisse elastische Verformbarkeit auf. Dies hat den Vorteil, dass bei auftretenden Rissen an der Außenseite des Stapels das Lotmaterial gedehnt wird und den Riss überbrücken kann, ohne sofort zu reißen.

Zur Verbesserung der Lötbarkeit kann die eingebrannte Grundmetallisierung oberflächenbehandelt sein.

In einer Ausführungsform befindet sich zwischen der Außenelektrode und der Grundmetallisierung eine durchgängige Lotschicht.

Vorzugsweise bedeckt die Lotschicht den Bereich der Grundmetallisierung flächig, auf den das Drahtgewebe aufgebracht ist. Dies kann dazu führen, dass die Grundmetallisierung in dem Bereich, in dem das Drahtgewebe aufgebracht ist, nicht von außen sichtbar ist. Das Drahtgewebe liegt auf der Lotschicht auf oder ist teilweise oder vollständig in der Lotschicht versunken. Das Drahtgewebe ist mittels der Lotschicht am Stapel befestigt. Im Fall, dass Drähte in der Lotschicht versunken sind, können sie auch direkt an die Außenseite des Stapels angrenzen und sind von der Lotschicht seitlich eingeschlossen. Auch dieser Fall soll hier mit eingeschlossen sein. Eine derartige durchgängige Lotschicht ist einfach aufzubringen und kostengünstig herzustellen.

In einer Ausführungsform sind die Drähte im 90°-Winkel miteinander verwebt. Vorzugsweise schließen die Drähte mit der Stapelrichtung einen Winkel von 45° ein.

Dies hat den Vorteil, dass bei Auftreten einer Zugspannung entlang der Stapelrichtung ein derartiges Drahtgewebe eine geringere Gesamtdehnung erfährt, als ein Drahtgewebe, bei dem Drähte entlang der Stapelrichtung angeordnet sind. Eine Zugspannung tritt beispielsweise auf, wenn Risse senkrecht zur Stapelrichtung des Aktors entstehen. Beispielsweise entspricht die Stapelrichtung des Aktors auch der Hubrichtung. In diesem Fall wird auch im normalen Betrieb des Piezoaktors das Drahtgewebe weniger beansprucht und eine zuverlässige Kontaktierung gewährleistet.

In einer Ausführungsform weist das Drahtgewebe Drähte mit einem leitfähigen Trägermaterial auf.

Das Trägermaterial bildet dabei das Grundgerüst der Drähte. Auf dieses Trägermaterial kann zur Verbesserung der Lötbarkeit oder der elektrischen Leitfähigkeit des Drahtgewebes eine Beschichtung aufgebracht sein.

Beispielsweise enthält das Trägermaterial ein Metall, z. B. Stahl, Kupfer oder eine Kupferlegierung, oder ein elektrisch leitfähiges Polymer. Insbesondere kann das Trägermaterial auch aus einem oder mehreren dieser Materialien bestehen.

Die Beschichtung enthält beispielsweise wenigstens ein Metall aus der Menge Kupfer und Zinn. Vorzugsweise enthalten die Drähte Stahl und sind zumindest teilweise mit einem oder mehreren Metallen aus der Menge Kupfer und Zinn beschichtet, wodurch eine gute Benetzbarkeit mit Lot erzielt werden kann.

In einer alternativen Ausführungsform weist das Drahtgewebe Drähte mit einem isolierenden Trägermaterial auf. Beispielsweise enthält das Trägermaterial ein isolierendes Polymer oder ein isolierendes Material wie Holz. Bei Drähten aus nicht leitenden Grundmaterialien kann durch eine metallische Beschichtung eine ausreichende Leitfähigkeit erzielt werden.

Vorzugsweise ist das Trägermaterial der Drähte elastisch.

Dies hat den Vorteil, dass sich bei einer mechanischen Belastung die Drähte elastisch verformen und mit geringerer Wahrscheinlichkeit Risse in den Drähten entstehen. Beispielsweise tritt eine mechanische Belastung bei einem vorhandenen Riss an der Außenseite des Stapels auf, an dem das Drahtgewebe befestigt ist. Sind die Drähte elastisch, so erfahren sie eine Dehnung und können den Riss überbrücken.

In einer Ausführungsform ist die Außenelektrode als Drahtgewebe ausgebildet, das mehrere Lagen umfasst, wobei eine unterste Lage an die Außenseite des Stapels angrenzt. Diese unterste Lage ist vollflächig an der Außenseite des Stapels befestigt.

Bei einem mehrlagigen Drahtgewebe wird die Zuverlässigkeit der Außenelektrode erhöht und die Wahrscheinlichkeit für das Entstehen eines Risses, der die Außenelektrode durchtrennt, erniedrigt. Das Drahtgewebe kann zweilagig ausgeführt sein. Vorzugsweise ist die obere Lage an die untere Lage angelötet.

Beispielsweise wird das mehrlagige Drahtgewebe durch Falten eines Drahtgewebes hergestellt. Zur Herstellung eines zweilagigen Drahtgewebes kann ein einlagiges Drahtgewebe von zwei gegenüberliegenden Längsseiten aus nach innen gefaltet werden, so dass sich die Längsseiten in der Mitte des Drahtgewebes treffen. Die Ränder der Längsseiten können anschließend miteinander verlötet werden.

Weiterhin wird ein Verfahren zum Anbringen einer Außenelektrode auf einem Piezoaktor angegeben. Dabei wird ein Stapel aus piezoelektrischen Schichten und dazwischen liegenden Elektrodenschichten bereitgestellt. Auf einer Außenseite des Stapels ist eine Grundmetallisierung aufgebracht und eingebrannt. Beispielsweise kann die Grundmetallisierung während oder nach eines Sintervorganges eingebrannt sein.

Zudem wird ein Drahtgewebe bereitgestellt. Das Drahtgewebe wird mit Lotmaterial beschichtet. Beispielsweise wird ein Lotmaterial wie Zinn, eine Zinnlegierung, Antimon oder Blei durch galvanisches Abscheiden auf das Drahtgewebe aufgebracht. Das Drahtgewebe wird anschließend auf die Grundmetallisierung aufgelegt und erwärmt, so dass das Lotmaterial schmilzt und eine Verlötung des Drahtgewebes mit der Grundmetallisierung erzielt wird.

Vorzugsweise ist die Menge an verwendetem Lotmaterial dabei so gewählt, dass eine vollflächige Verlötung des Drahtgewebes mit der Grundmetallisierung erreicht werden kann. Andererseits darf die Menge an Lotmaterial auch nicht zu gro0 sein, damit die Funktionsfähigkeit des Aktors nicht beeinträchtigt wird.

In einer Ausführungsform wird das Gewebe während des Lötvorgangs an die Grundmetallisierung angedrückt. Dies hat den Vorteil, dass das Gewebe beim Löten stärker in die Lotschicht eintaucht und eine stabilere Verbindung hergestellt werden kann. Zudem kann durch das Andrücken zuverlässiger eine vollflächige Verlötung des Drahtgewebes mit der Grundmetallisierung erreicht werden. Um die vollflächige Verlötung des Drahtgewebes zu gewährleisten, muss der Anpressdruck auf die weiteren Prozessparameter, wie z. B. Art und Menge des verwendeten Lotmaterials, Temperatur beim Lötvorgang und Art des Drahtgewebes, abgestimmt sein. Durch das Andrücken kann zudem erreicht werden, dass das Gewebe eng an der Seitenfläche des Aktors anliegt, so dass eine platzsparende Kontaktierung ermöglicht wird.

Im Folgenden werden der angegebene Piezoaktor und seine vorteilhaften Ausgestaltungen anhand von schematischen und nicht maßstabsgetreuen Figuren erläutert. Es zeigen:
Figur 1 einen Piezoaktor in einer perspektivischen Ansicht,
Figur 2 einen Piezoaktor in einer seitlichen Aufsicht,
Figur 3 einen Piezoaktor im Querschnitt senkrecht zur Stapelrichtung.

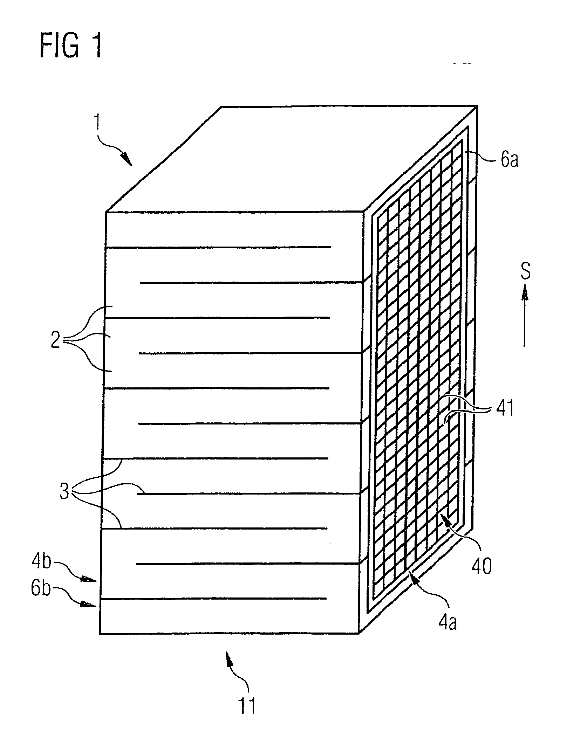

Figur 1 zeigt einen Piezoaktor 1 in Vielschichtbauweise, bei dem eine Vielzahl von piezoelektrischen Schichten 2, beispielsweise keramische Schichten, entlang einer Stapelrichtung S zu einem Stapel 11 angeordnet sind. Die Stapelrichtung S entspricht einer Längsrichtung des Piezoaktors 1. Zwischen den piezoelektrischen Schichten 2 sind Elektrodenschichten 3 angeordnet. An zwei Seitenflächen des Stapels 11 sind Außenelektroden 4a, 4b in Form von jeweils einem Drahtgewebe 40 aufgebracht, bei dem mit Kupfer beschichtete Drähte 41 aus einem Trägermaterial aus Stahl miteinander verwebt sind. Die Außenelektroden 4a, 4b sind an Grundmetallisierungen 6a, 6b auf zwei gegenüberliegenden Seitenflächen des Stapels 11 vollflächig angelötet.

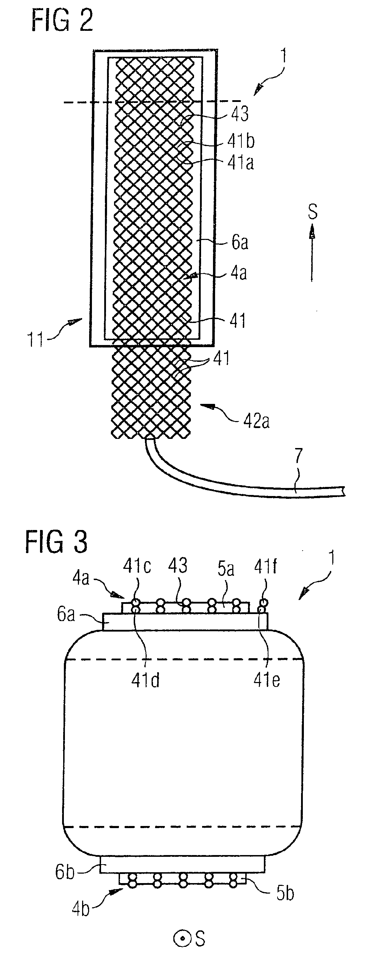

Figur 2 zeigt einen Piezoaktor 1 mit einer als Drahtgewebe 40 ausgebildeten Außenelektrode 4a. Die Drähte 41a, 41b des Drahtgewebes 40 sind im 90°-Winkel miteinander verwebt und schließen jeweils einen 45°-Winkel mit der Stapelrichtung S ein. Auf diese Weise erfahren die Drähte bei einer Zugspannung in Richtung der Stapelrichtung S eine geringere Beanspruchung, als bei einer Anordnung der Drähte entlang der Stapelrichtung S. Die Drähte 41a, 41b sind miteinander verwebt, so dass an einem Maschenknoten 43 ein Draht 41a unten und ein Draht 41b oben liegt. Entlang eines Drahtes 41a, 41b liegt der jeweilige Draht 41a, 41b an den Maschenknoten abwechselnd oben und unten.

Die Außenelektrode 4a reicht hier entlang der Stapelrichtung S mit einem freien Ende 42a über den Stapel 11 hinaus. Am freien Ende 42a ist ein Anschlussdraht 7 befestigt. Der Anschlussdraht ist beispielsweise an das freie Ende 42a der Außenelektrode 4a angelötet oder angeschweißt. Alternativ dazu kann die Außenelektrode 4a, wie in Figur 1 gezeigt, innerhalb der Seitenfläche des Stapels 11 enden. Der Anschlussdraht 7 kann dann auch in einem Bereich der Außenelektrode 41a angelötet sein, der an der Außenseite des Stapels 11 befestigt ist.

Figur 3 zeigt einen Piezoaktor 1 gemäß Figur 2 im Querschnitt senkrecht zur Stapelrichtung S. Der Querschnitt verläuft dabei entlang der in Figur 2 eingezeichneten, gestrichelten Linie und kreuzt Maschenknoten 43 des Drahtgewebes 40. Im Schnittbild sind Grundmetallisierungen 6a, 6b zu sehen, die auf zwei einander gegenüber liegenden Seitenflächen des Piezoaktors 1 aufgebracht sind. An den Grundmetallisierungen 6a, 6b sind die Außenelektroden 4a, 4b mittels einer Lotschicht 5a, 5b vollflächig befestigt.

Die Außenelektroden 4a, 4b sind vollflächig mit den Seitenflächen des Stapels 11 verbunden. Insbesondere sind die Drahtabschnitte, die der Außenseite des Stapels 11 zugewandt sind, direkt am Stapel 11 befestigt. An den Maschenknoten 43 kreuzen sich jeweils zwei Drähte, wobei einer der Drähte 41c oben liegt und der weitere Draht 41d unten liegt. Der unten liegende Draht 41d ist hier in direktem mechanischen Kontakt mit der Grundmetallisierung 6a und wird von der Lotschicht 5a seitlich umschlossen. Die Lotschicht 5a bedeckt die Grundmetallisierung 6a flächig in dem Sinne, dass sie nur von Drähten 41b unterbrochen ist. Die Grundmetallisierung 6a ist somit im Bereich der Außenelektrode 4a nicht von außen sichtbar, da sie von der Lotschicht 5a und der Außenelektrode 4a bedeckt ist. Die oberen Drähte 41c sind hier ebenfalls direkt mittels der Lotschicht 5a am Stapel 11 befestigt. Alternativ dazu können sie jedoch auch nur an den unteren Drähten 41b befestigt sein. Wesentlich ist, dass die Drahtabschnitte, die an die Außenseite des Stapels 11 angrenzen, direkt am Stapel 11 befestigt sind. Dabei kann sich das Lotmaterial zwischen den Drähten und der Außenseite des Stapels 11 befinden oder seitlich an den Drähten haften. Das Lotmaterial muss nicht wie hier gezeigt als-durchgängige Lotschicht 5a ausgebildet sein, sondern es genügt, wenn das Lotmaterial eine Form hat, die eine vollflächige Befestigung des Drahtgewebes 40 am Stapel 11 sicherstellt.

Bei einer vollflächigen Befestigung soll jedoch auch der Fall eingeschlossen sein, dass einzelne Drähte, die z. B. am seitlichen Rand des Drahtgewebes 40 zu finden sind, nicht an der Außenseite des Stapels 11 befestigt sind. Ein derartiger Draht 41e ist auch in Figur 3 zu sehen. Dieser Draht 41e ist der untere Draht eines Maschenknotens 43 und grenzt an den Stapel 11 an. Er befindet sich außerhalb der Lotschicht 5a und ist nicht an der Außenseite des Stapels 11 befestigt. Auch der oben liegende Draht 41f ist nicht an der Außenseite des Stapels befestigt, sondern lediglich durch eine Lotverbindung (nicht eingezeichnet) mit dem unteren Draht 41e verbunden.

### Bezugszeichenliste

- 1: Piezoaktor
- 11: Stapel
- 2: piezoelektrische Schicht
- 3: Elektrodenschicht
- 4a, 4b: Außenelektrode
- 40: Drahtgewebe
- 41, 41a, 41b, 41c, 41d, 41e, 41f: Draht
- 42a, 42b: freies Ende
- 43: Maschenknoten
- 5a, 5b: Lotschicht
- 6a, 6b: Grundmetallisierung
- 7: Anschlussdraht

- S: Stapelrichtung

## Patentansprüche

1. Piezoaktor in Vielschichtbauweise
- mit einem Stapel (11) aus piezoelektrischen Schichten (2) und dazwischen liegenden Elektrodenschichten (3),
- mit wenigstens einer als Drahtgewebe (40) ausgebildeten Außenelektrode (4a, 4b) zur elektrischen Kontaktierung der Elektrodenschichten (3),
- **dadurch gekennzeichnet, dass** die Außenelektrode (4a, 4b) vollflächig an einer Grundmetallisierung (6a, 6b) an einer Außenseite des Stapels (11) angelötet ist.

2. Piezoaktor nach Anspruch 1,
- bei dem das Drahtgewebe (40) Maschenknoten (43) mit einem oben liegenden Draht (41c) und einem unten liegenden Draht (41d) aufweist.

3. Piezoaktor nach Anspruch 2,
- bei dem an den Maschenknoten (43) zumindest der unten liegende Draht (41d) an der Außenseite des Stapels (11) befestigt ist.

4. Piezoaktor nach einem der Ansprüche 1 bis 3,
- bei dem das Drahtgewebe (40) Drähte (41) mit einem leitfähigen Trägermaterial aufweist.

5. Piezoaktor nach Anspruch 4,
- bei dem das Trägermaterial ein Material aus der Menge Stahl, Kupfer und einer Kupferlegierung enthält.

6. Piezoaktor nach einem der Ansprüche 1 bis 5,
- bei dem das Drahtgewebe (40) Drähte (41) mit einem isolierenden Trägermaterial aufweist.

7. Piezoaktor nach einem der Ansprüche 1 bis 6,
- bei dem das Trägermaterial elastisch ist.

8. Piezoaktor nach einem der Ansprüche 1 bis 7,
- bei dem das Drahtgewebe (40) Drähte (41) aufweist, die mit einer leitfähigen Beschichtung versehen sind.

9. Piezoaktor nach Anspruch 8,
- bei dem die leitfähige Beschichtung wenigstens ein Metall aus der Menge Kupfer und Zinn enthält.

10. Piezoaktor nach einem der Ansprüche 1 bis 9,
- bei dem das Drahtgewebe (40) Drähte (41) aufweist, die im 90°-Winkel miteinander verwebt sind und mit der Stapelrichtung (S) des Stapels (11) einen Winkel von 45° einschließen.

11. Piezoaktor nach einem der Ansprüche 1 bis 10,
- bei dem die Grundmetallisierung (6a, 6b) wenigstens eine eingebrannte Metallpaste aufweist.

12. Piezoaktor nach einem der Ansprüche 1 bis 11,
- bei dem die Grundmetallisierung (6a, 6b) zur Verbesserung der Lötbarkeit oberflächenbehandelt ist.

13. Piezoaktor nach einem der Ansprüche 1 bis 12,
- bei dem sich zwischen der Außenelektrode (4a, 4b) und der Grundmetallisierung (6a, 6b) eine durchgängige Lotschicht (5) befindet.

14. Piezoaktor nach einem der Ansprüche 1 bis 13,
- bei dem das Drahtgewebe (40) mehrere Lagen umfasst und die unterste Lage vollflächig an der Außenseite des Stapels (11) befestigt ist.

15. Verfahren zum vollflächigen Anbringen einer Außenelektrode auf einen Piezoaktor umfassend die Schritte:
A) Bereitstellen eines Stapels (11) aus piezoelektrischen Schichten (2) und dazwischen liegenden Elektrodenschichten (3) mit einer auf eine Außenseite aufgebrachten und eingebrannten Grundmetallisierung (6a),
B) Bereitstellen eines Drahtgewebes (40),
C) Beschichten des Drahtgewebes (40) mit Lotmaterial,
D) Auflegen des Drahtgewebes (40) auf die Grundmetallisierung (6a),
E) Erwärmen des Drahtgewebes (40) und dabei Verlöten des Drahtgewebes (40) mit der Grundmetallisierung (6a), wobei das Drahtgewebe (40) während des Lötvorgangs an die Grundmetallisierung (6) angedrückt wird.

## Claims

1. Multilayer piezo actuator
- having a stack (11) of piezoelectric layers (2) and electrode layers (3) located between them,
- having at least one outer electrode (4a, 4b), which is in the form of a wire mesh (40), for making electrical contact with the electrode layers (3),
- **characterized in that** the outer electrode (4a, 4b) is soldered over its entire area to a basic metallization (6a, 6b) on an outer face of the stack (11).

2. Piezo actuator according to Claim 1,
- wherein the wire mesh (40) has mesh nodes (43) with a wire (41c) located at the top and a wire (41d) located at the bottom.

3. Piezo actuator according to Claim 2,
- wherein at least the wire (41d) located at the bottom is attached to the outer face of the stack (11) at the mesh node (43).

4. Piezo actuator according to one of Claims 1 to 3,
- wherein the wire mesh (40) has wires (41) with a conductive carrier material.

5. Piezo actuator according to Claim 4,
- wherein the carrier material contains a material from the group steel, copper or a copper alloy.

6. Piezo actuator according to one of Claims 1 to 5,
- wherein the wire mesh (40) has wires (41) with an insulating carrier material.

7. Piezo actuator according to one of Claims 1 to 6,
- wherein the carrier material is elastic.

8. Piezo actuator according to one of Claims 1 to 7,
- wherein the wire mesh (40) has wires (41) which are provided with a conductive coating.

9. Piezo actuator according to Claim 8,
- wherein the conductive coating contains at least one metal from the group copper and tin.

10. Piezo actuator according to one of Claims 1 to 9,
- wherein the wire mesh (40) has wires (41) which are woven with one another at an angle of 90°, and which include an angle of 45° with the stacking direction (S) of the stack (11).

11. Piezo actuator according to one of Claims 1 to 10,
- wherein the basic metallization (6a, 6b) has at least one burnt-in metal paste.

12. Piezo actuator according to one of Claims 1 to 11,
- wherein the basic metallization (6a, 6b) is surface-treated in order to improve the solderability.

13. Piezo actuator according to one of Claims 1 to 12,
- wherein a continuous solder layer (5) is located between the outer electrode (4a, 4b) and the basic metallization (6a, 6b).

14. Piezo actuator according to one of Claims 1 to 13,
- wherein the wire mesh (40) comprises a plurality of layers, and the bottom layer is attached over its entire area to the outer face of the stack (11).

15. Method for fitting an outer electrode over its entire area to a piezo actuator comprising the following steps:
A) Provision of a stack (11) of piezoelectric layers (2) and electrode layers (3) located between them with a basic metallization (6a) which is burnt in and applied to an outer face,
B) Provision of a wire mesh (40),
C) Coating of the wire mesh (40) with solder material,
D) Placing the wire mesh (40) on the basic metallization (6a),
E) Heating the wire mesh (40) and in the process soldering the wire mesh (40) to the basic metallization (6a), with the wire mesh (40) being pressed onto the basic metallization (6) during the soldering process.

## Revendications

1. Piézoactionneur de type stratifié, présentant
une pile (11) de couches piézoélectriques (2) entre lesquelles sont disposées des couches d'électrode (3),
au moins une électrode extérieure (4a, 4b) configurée comme tissu (40) de fils et assurant le contact électrique avec les couches d'électrode (3), **caractérisé en ce que**
l'électrode extérieure (4a, 4b) est brasée sur toute la surface d'une métallisation de base (6a, 6b) appliquée sur le côté extérieur de la pile (11).

2. Piézoactionneur selon la revendication 1, dans lequel le tissu (40) de fils présente des noeuds de mailles (43) présentant un fil supérieur (41c) et un fil inférieur (41d).

3. Piézoactionneur selon la revendication 2, dans lequel au moins le fil inférieur (41d) du noeud de mailles (43) est fixé sur le côté extérieur de la pile (11).

4. Piézoactionneur selon l'une des revendications 1 à 3, dans lequel le tissu (40) de fils présente des fils (41) dotés d'un matériau de support conducteur.

5. Piézoactionneur selon la revendication 4, dans lequel le matériau de support contient un matériau sélectionné dans l'ensemble constitué de l'acier, du cuivre et d'un alliage de cuivre.

6. Piézoactionneur selon l'une des revendications 1 à 5, dans lequel le tissu (40) de fils présente des fils (41) avec un matériau de support isolant.

7. Piézoactionneur selon l'une des revendications 1 à 6, dans lequel le matériau de support est élastique.

8. Piézoactionneur selon l'une des revendications 1 à 7, dans lequel le tissu (40) de fils présente des fils (41) dotés d'un revêtement conducteur.

9. Piézoactionneur selon la revendication 8, dans lequel le revêtement conducteur contient au moins un métal de l'ensemble constitué du cuivre et du zinc.

10. Piézoactionneur selon l'une des revendications 1 à 9, dans lequel le tissu (40) de fils présente des fils (41) tissés les uns avec les autres sous un angle de 90° et formant un angle de 45° avec la direction (S) d'empilement de la pile (11).

11. Piézoactionneur selon l'une des revendications 1 à 10, dans lequel la métallisation de base (6a, 6b) présente au moins une pâte métallique incorporée par cuisson.

12. Piézoactionneur selon l'une des revendications 1 à 11, dans lequel la métallisation de base (6a, 6b) est traitée en surface pour améliorer son aptitude au brasage.

13. Piézoactionneur selon l'une des revendications 1 à 12, dans lequel une couche continue de brasure (5) est située entre l'électrode extérieure (4a, 4b) et la métallisation de base (6a, 6b).

14. Piézoactionneur selon l'une des revendications 1 à 13, dans lequel le tissu (40) de fils présente plusieurs couches, la couche inférieure étant fixée sur toute sa surface sur le côté extérieur de la pile (11).

15. Procédé pour appliquer une électrode extérieure sur toute la surface d'un piézoactionneur, le procédé comportant les étapes qui consistent à :
A) préparer une pile (11) constituée de couches piézoélectriques (2) entre lesquelles sont disposées des couches d'électrode (3), avec une métallisation de base (6a) appliquée sur un côté extérieur et incorporée par cuisson,
B) préparer un tissu (40) de fils,
C) revêtir le tissu (40) de fils d'un matériau de brasage,
D) appliquer le tissu (40) de fils sur la métallisation de base (6a) et
E) chauffer le tissu (40) de fils pour ainsi braser le tissu (40) de fils sur la métallisation de base (6a), le tissu (40) de fils étant repoussé contre la métallisation de base (6) pendant l'opération de brasage.
